# EUROPEAN PATENT APPLICATION

(11) **EP 4 632 405 A1**
(43) Date of publication of application: **15.10.2025**
(21) Application number: 23899298.6
(22) Date of filing: 04.05.2023
(51) Int. Cl.: G01R 31/388, G01R 31/374, H02J 7/00, H01M 10/44, G01R 35/00

(54) **BATTERY MODULE DISCHARGE CALIBRATION APPARATUS AND BATTERY MODULE DISCHARGE CALIBRATION METHOD**

(30) Priority: 09.12.2022 CN 202211588792
(71) Applicant: Sungrow Power Supply Co., Ltd., Hefei, Anhui 230088 (CN)
(72) Inventor: DONG, Wengong, Hefei, Anhui 230088 (CN); CHEN, Fei, Hefei, Anhui 230088 (CN); REN, Jingsong, Hefei, Anhui 230088 (CN); CHEN, Qiangdong, Hefei, Anhui 230088 (CN); LI, Xuteng, Hefei, Anhui 230088 (CN); HAN, Chen, Hefei, Anhui 230088 (CN); JIN, Yongwei, Hefei, Anhui 230088 (CN)
(74) Representative: Epping - Hermann - Fischer
(86) International application number: PCT/CN2023/091951
(87) International publication number: WO 2024/119704

(57) **Abstract**

A battery module discharge calibration apparatus and a battery module discharge calibration method. The battery module discharge calibration apparatus comprises: a battery module interface, used for connecting a battery module; a load assembly, the load assembly being electrically connected to the battery module interface, and when the battery module is connected to the battery module interface, the load assembly being used for consuming electric energy output by the battery module; and an electric control assembly, a communication end of the electric control assembly being connected to the battery module interface, and a control end of the electric control assembly being connected to the load assembly. The electric control assembly is used for acquiring battery cell parameters in the battery module when the battery module is connected to the battery module interface, and controlling, according to the battery cell parameters, the load assembly to consume the electric energy output by the battery module. When determining, according to the battery cell parameters, that the voltage of the battery module reaches a preset voltage threshold value, the electric control assembly is further used for adjusting the output current of the battery module according to the battery cell parameters, and performing SOC calibration for the connected battery module. The present application can solve the problem of existing calibration apparatuses being complex to use.

## Description

This application claims the priority to Chinese Patent Application No. 202211588792.X, titled "BATTERY MODULE DISCHARGE CALIBRATION APPARATUS AND BATTERY MODULE DISCHARGE CALIBRATION METHOD", filed on December 9, 2022 with the China National Intellectual Property Administration, which is incorporated herein by reference in its entirety.

### FIELD

The present disclosure relates to the technical field of battery modules, and in particular to a discharge calibration apparatus for a battery module and a discharge calibration method for a battery module.

### BACKGROUND

An SOC of a battery module changes after operation and maintenance, replacement and supplement of the battery module. An SOC of an updated battery module may not be accurately determined by a system. If an additional module is directly connected to the original system, resulting in a large deviation in an SOC of a cell, and actual battery capacity fails to be fully utilized due to the Cannikin law. Therefore, an operator usually uses a calibration device to calibrate the SOC of the battery module so that the battery capacity of the battery module can be utilized normally. However, a conventional calibration device is provided with excessive components in a complex structure, resulting in numerous and complicated connection cables between the calibration device and the battery module. The calibration device complicates operations and is unsuitable for non-professionals.

### SUMMARY

A discharge calibration apparatus for a battery module is provided according to the present disclosure, to address the operational complexity of conventional calibration devices.

To achieve the forgoing objective, a discharge calibration apparatus for a battery module is provided according to the present disclosure. The discharge calibration apparatus includes:
a battery module interface, configured to connect the battery module;
a load component, electrically connected to the battery module interface, and configured to consume electric energy outputted by the battery module after the battery module is connected to the battery module interface; and
an electric control component, where
a communication terminal of the electric control component is connected to the battery module interface, and a control terminal of the electric control component is connected to the load component;
the electric control component is configured to, after the battery module is connected to the battery module interface: acquire a cell parameter of the battery module; and control, based on the cell parameter, the load component to consume the electric energy outputted by the battery module; and
the electric control component is further configured to, in response to determining, based on the cell parameter, that a voltage of the battery module reaches a preset voltage threshold, regulate an output current of the battery module based on the cell parameter and calibrate an SOC of the battery module.

In an embodiment, the load component includes multiple electrical loads and multiple switching transistors, the multiple electrical loads are arranged in parallel, and the multiple switching transistors are connected in series with the multiple electrical loads in one-to-one correspondence, and controlled terminals of the multiple switching transistors are connected to the electric control component. The electric control component is further configured to determine a maximum output current of the battery module based on the cell parameter, and turn on a switching transistor of the multiple switching transistors in the load component based on the maximum output current, to connect a quantity of electrical loads corresponding to the switching transistor among the plurality of electrical loads to the battery module.

In an embodiment, the electric control component is further configured to, in response to determining, based on the cell parameter, that the cell voltage of the battery module, reaches the preset voltage threshold: control, based on the cell voltage, the multiple switching transistors in the load component to sequentially disconnect the multiple electrical loads from the battery module, to gradually reduce the output current of the battery module, and calibrate the SOC of the battery module.

In an embodiment, the electric control component is further configured to, in response to determining, based on the cell parameter, that the voltage of the battery module is less than or equal to a cut-off voltage, control the load component to stop consuming the electric energy outputted by the battery module and calibrate the SOC of the battery module with an initial SOC.

In an embodiment, the electric control component includes:
a main controller, where a communication terminal of the main controller is connected to the battery module interface, and a control terminal of the main controller is connected to the load component; and the main controller is configured to, after the battery module is connected to the battery module interface: acquire the cell parameter of the battery module and control, based on the cell parameter, the load component to consume the electric energy outputted by the battery module; and
a voltage detection circuit, where an input terminal of the voltage detection circuit is connected to the battery module interface, and an output terminal of the voltage detection circuit is connected to the main controller; the voltage detection circuit is configured to, after the battery module is connected to the battery module interface: detect a battery voltage of the battery module and output a battery voltage detection signal corresponding to the battery voltage to the main controller; where the main controller is further configured to calibrate the OCV of the connected battery module based on the battery voltage detection signal.

In an embodiment, the discharge calibration apparatus for a battery module further includes:
a miniature circuit breaker, connected between the battery module interface and the load component, where the miniature circuit breaker is configured to electrically connect, when closed, the battery module interface and the load component; and
a shunt release, electrically connected to the electric control component, and interlinked with the miniature circuit breaker; where the electric control component is further configured to, in response to determining, based on the cell parameter, that the cell voltage of the battery module is less than a cut-off voltage: close the shunt release to trip the miniature circuit breaker.

In an embodiment, the discharge calibration apparatus for a battery module further includes an undervoltage protection circuit. An input terminal of the undervoltage protection circuit is connected to the battery module interface, and an output terminal of the undervoltage protection circuit is connected to a main controller. The undervoltage protection circuit is configured to: detect a battery voltage of the battery module after the battery module is connected to the battery module interface; and output, upon determining undervoltage of the battery module, an undervoltage protection signal to the main controller. The main controller closes, in response to the undervoltage protection signal, the shunt release to trip the miniature circuit breaker.

In an embodiment, the discharge calibration apparatus for a battery module further includes a voltage conversion circuit. An input terminal of the voltage conversion circuit is connected to the battery module interface, and an output terminal of the voltage conversion circuit is connected to the electric control component. The voltage conversion circuit is configured to convert, after the battery module is connected to the battery module interface, a voltage outputted by the battery module into a power supply voltage and output the power supply voltage to the electric control component for supplying the electric control component.

In an embodiment, the discharge calibration apparatus for a battery module further includes: a cooling fan, where a controlled terminal of the cooling fan is connected to the electric control component; and a temperature detection module connected to the electric control component, where the temperature detection module is configured to: detect a temperature of the load component and a temperature of an air outlet of the cooling fan; and output temperature detection signals corresponding to the temperatures. The electric control component controls operation of the cooling fan based on the temperature detection signal; and/or the electric control component turns on a switching transistor in the load component based on the temperature detection signal, to regulate an output current of the battery module.

In an embodiment, the temperature detection module includes:
a first temperature sensor, connected to the electric control component, where the first temperature sensor is configured to: detect the temperature of the load component; and output a first temperature detection signal corresponding to the temperature of the load component, where the electric control component controls operation of the cooling fan based on the first temperature detection signal, to cool the load component; and
a second temperature sensor, arranged at the air outlet of the cooling fan, where the second temperature sensor is configured to: detect the temperature of the air outlet of the cooling fan; and output a second temperature detection signal corresponding to the temperature of the air outlet, where the electric control component turns on the corresponding switching transistor in the load component based on the first temperature detection signal and the second temperature detection signal, to regulate the output current of the battery module.

In an embodiment, the discharge calibration apparatus for a battery module further includes: a main switching circuit arranged between the load component and the battery module interface, where a controlled terminal of the main switching circuit is connected to the electric control component; and the main switching circuit is configured to electrically connect, when connected, the load component to the battery module interface.

A discharge calibration method for a battery module is provided according to the present disclosure, applied to the discharge calibration apparatus for a battery module. The discharge calibration method includes:
acquiring the cell parameter of the battery module, and controlling, based on the cell parameter, the load component to consume the electric energy outputted by the battery module;
regulating, in response to determining, based on the cell parameter, that the voltage of the battery module reaches the preset voltage threshold, the output current of the battery module based on the cell parameter and calibrating the SOC of the battery module; and
controlling, in response to determining, based on the cell parameter, that the voltage of the battery module is less than or equal to a cut-off voltage, the load component to stop consuming the electric energy outputted by the battery module and calibrating the SOC of the battery module with an initial SOC.

In an embodiment, the acquiring the cell parameter of the battery module, and controlling, based on the cell parameter, the load component to consume the electric energy outputted by the battery module includes:
acquiring the cell parameter of the battery module, determining a maximum output current of the battery module based on the cell parameter, and turning on a switching transistor in the load component based on the maximum output current, to connect a quantity of an electrical load corresponding to the switching transistor to the battery module; and
determining the cell voltage of the battery module based on the cell parameter and regulating the output current of the battery module based on the cell voltage of the battery module.

In an embodiment, the regulating, in response to determining, based on the cell parameter, that the voltage of the battery module reaches the preset voltage threshold, the output current of the battery module based on the cell parameter and calibrating the SOC of the battery module includes:
in response to determining, based on the cell parameter, that the voltage of the battery module reaches the preset voltage threshold,
controlling, based on the cell voltage, multiple switching transistors in the load component to sequentially disconnect multiple electrical loads from the battery module based on the cell voltage to gradually reduce the output current of the battery module; and
calibrating the SOC of the battery module.

In technical solutions of the present disclosure, the battery module interface, the load component and the electric control component are arranged. After the battery module is connected to the battery module interface, the electric control component can perform discharge SOC calibration on the connected battery module based on the acquired cell parameter, thus achieving the SOC calibration function. The discharge calibration apparatus for a battery module according to the present disclosure is provided with only one battery module interface, which is implemented in a simple connection manner and easy to operate, allowing even non-professionals to quickly use the apparatus, thus reducing the complexity and improving the applicability of the discharge calibration apparatus for a battery module, thus solving the problem of operational complexity of conventional calibration apparatuses.

### BRIEF DESCRIPTION OF THE DRAWINGS

For more clearly illustrating technical solutions in the embodiments of the present disclosure or the technical solution in the conventional technology, drawings to be used in the description of the embodiments or the conventional technology are briefly described hereinafter. Apparently, the drawings in the following description show only several embodiments of the present disclosure. For those skilled in the art, other drawings may be obtained based on the structures shown by these drawings without any creative efforts.
FIG. 1 is a schematic diagram of a functional module of a discharge calibration apparatus for a battery module according to an embodiment of the present disclosure;
FIG. 2 is a schematic diagram of a functional module of a discharge calibration apparatus for a battery module according to another embodiment of the present disclosure;
FIG. 3 is a schematic diagram of a functional module of a discharge calibration apparatus for a battery module according to another embodiment of the present disclosure;
FIG. 4 is a schematic structural diagram of a circuit of a discharge calibration apparatus for a battery module according to an embodiment of the present disclosure;
FIG. 5 is a schematic structural diagram of a discharge calibration apparatus for a battery module according to an embodiment of the present disclosure;
FIG. 6 is a flowchart of a discharge calibration method for a battery module according to an embodiment of the present disclosure;
FIG. 7 is a detailed flowchart of a discharge calibration method for a battery module according to an embodiment of the present disclosure; and
FIG. 8 is a detailed flowchart of a discharge calibration method for a battery module according to another embodiment of the present disclosure.

Reference numerals are as follows:
10: battery module interface; 20: load component; 30: electric control component; 31: main controller; 32: voltage detection circuit; 33: undervoltage protection circuit; 40: miniature circuit breaker; 50: shunt release; 60: first temperature sensor; 70: cooling fan; 80: second temperature sensor; 90: voltage conversion circuit; 100: main switching circuit; R1-R6: first resistor to sixth resistor; Q1-Q6: first switching transistor to sixth switching transistor.

Objectives, functional characteristics and advantages of the present disclosure are further described with reference to the drawings in conjunction with the embodiments.

### DETAILED DESCRIPTION

The technical solutions in the embodiments of the present disclosure are described clearly and completely hereinafter in conjunction with the drawings in the embodiments of the present disclosure. Apparently, the described embodiments are only a part rather than all of the embodiments of the present disclosure. Based on the embodiments of the present disclosure, all other embodiments obtained by those skilled in the art without any creative work fall into the protection scope of the present disclosure.

It should be noted that a directional indication (such as up, down, left, right, front, back...) in the embodiments of the present disclosure is merely used to explain a relative position relationship, movement or the like between components in a specific posture (as shown in the drawings). The directional indication changes as the specific posture varies.

In addition, in the present disclosure, terms, such as "first" and "second", are merely used for descriptive purposes and should not be understood as explicitly indicating or implying the relative importance or implicitly indicating the number of indicated technical features. Therefore, a feature defined with "first" or "second" may be at least one in number explicitly or implicitly. In addition, the technical solutions of the various embodiments can be combined with each other, in the ways that can be implemented by those skilled in the art. When the combination of technical solutions is contradictory or cannot be implemented, it should be considered that such a combination of technical solutions does not exist and is not within the protection scope of the present disclosure.

A discharge calibration apparatus for a battery module is provided according to the present disclosure.

At present, a conventional calibration device has a complex structure, resulting in a complicated connection manner between the calibration device and a battery module. The calibration device complicates operations and is unsuitable for non-professionals.

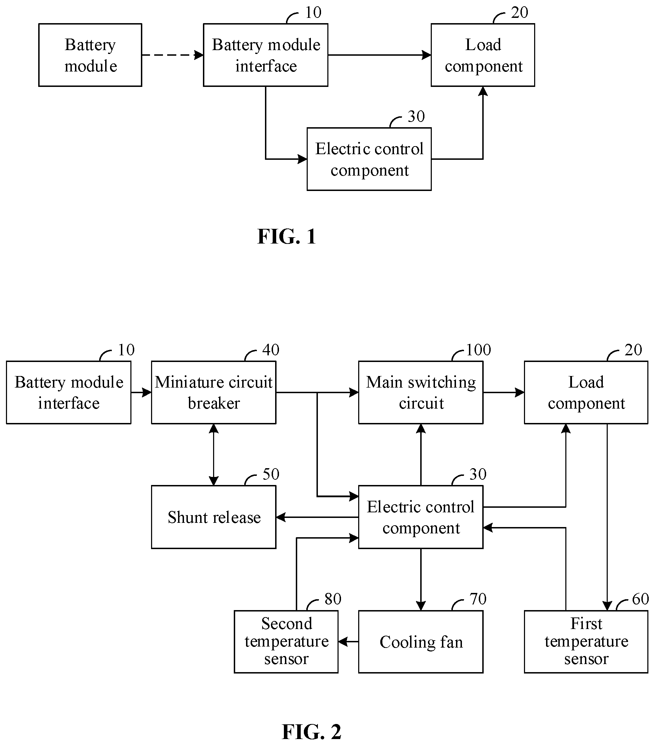

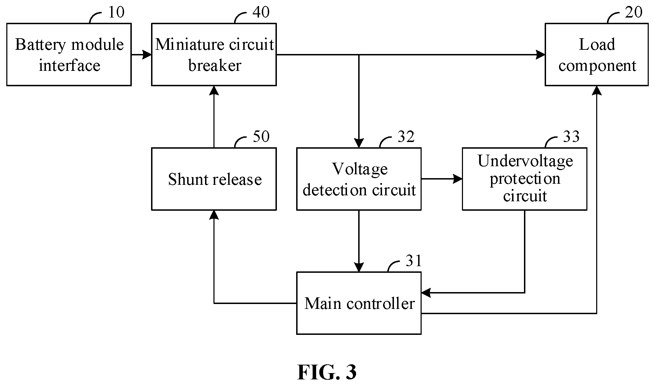

To solve the above problem, as shown in FIG. 1 to FIG. 3, in an embodiment, the discharge calibration apparatus for a battery module includes: a battery module interface 10, a load component 20 and an electric control component 30.

The battery module interface 10 is configured to connect a battery module.

The load component 20 is electrically connected to the battery module interface 10. The load component 20 is configured to consume electric energy outputted by the battery module after the battery module is connected to the battery module interface 10.

A communication terminal of the electric control component 30 is connected to the battery module interface 10. A control terminal of the electric control component 30 is connected to the load component 20. The electric control component 30 is configured to, after the battery module is connected to the battery module interface 10, acquire a cell parameter of the battery module and control, based on the cell parameter, the load component 20 to consume the electric energy outputted by the battery module.

The electric control component 30 is further configured to, in response to determining, based on the cell parameter, that a voltage of the battery module reaches a preset voltage threshold, regulate an output current of the battery module based on the cell parameter and calibrate an SOC of the battery module.

In the embodiment, the load component 20 is implemented by multiple electrical loads and multiple switching transistors. The multiple electrical loads are connected in parallel, and the multiple electrical loads are connected in series with the multiple switching transistors in one-to-one correspondence, and the multiple switching transistors are controlled by the electric control component 30.

In the discharge calibration apparatus, the electric control component 30 may turn on a switching transistor to control the load component 20 to consume the electric energy outputted by the battery module. Further, the electric control component 30 may turn on or off a switching transistor to change the number of electrical loads connected to the battery module, thereby regulating the output current of the battery module, that is, changing a discharge speed of the battery module. The electric control component 30 may control the discharge calibration apparatus for a battery module by using a microprocessor such as a single-chip microcomputer, FPGA, and CPLD.

After the battery module is connected to the battery module interface 10, the electric control component 30 establishes a communication connection with a battery management unit (BMU) in the battery module, and acquires the cell parameter of the battery module, such as an SOC, a cell voltage, a cell discharge rate or the like, from the BMU. After the battery module is connected to the battery module interface 10, the electric control component 30 may turn on a switching transistor in the load component 20 to electrically connect the corresponding electrical load to the battery module, so that the electrical load consumes the electric energy outputted by the battery module. In this way, the electric energy outputted by the battery module can rapidly reach an end of discharge, enabling the electric control component 30 to calibrate the SOC of the battery module.

During a discharge process of the battery module, the electric control component 30 determines the SOC of the battery module based on the acquired cell parameter, for example, the cell voltage, through an ampere-hour integration method, a static lookup table method, or the like, so as to calibrate the SOC of the battery module.

It should be understood that when the SOC of the battery module is between 10% and 90%, the cell voltage of the battery module is in a plateau phase during which the cell voltage experiences only a slight change. When the battery module is at an end of discharge or an end of charge, that is, the SOC of the battery module is between 0% and 10% or between 90% and 100%, the voltage of the battery module experiences a significant change due to cell characteristics. Hence, during the end of discharge or the end of charge of the battery module, a correspondence between the voltage and the SOC is determined more easily, and a calibrated SOC may be regarded as an actual SOC, so as to realize SOC calibration.

Therefore, in the embodiment, upon determining, based on the cell parameter, that the cell voltage of the battery module reaches a voltage corresponding to the SOC at the end of discharge, that is, the preset voltage threshold, the electric control component 30 calibrates the SOC of the battery module, improving the accuracy of the SOC calibration.

Furthermore, the preset voltage threshold is the voltage corresponding to the SOC at the end of discharge of the battery module, that is, a voltage corresponding to an SOC of 10% or below to which the battery module is discharged. Upon determining, based on the cell parameter, that the battery module reaches the preset voltage threshold, the electric control component 30 may further turn on or off switching transistors in the load component 20 to gradually reduce the number of connected electrical loads. In this way, the output current of the battery module is gradually reduced, thus slowing down a decrease of the cell voltage, and improving the precision of SOC calibration while protecting cells in the battery module.

The electric control component 30 may gradually reduce the output current of the battery module based on the acquired cell voltage of the battery module. When the cell voltage of the battery module decreases to a cut-off voltage, the electric control component 30 turns off the switching transistors in the load component 20, so that the battery module stops discharging.

The cut-off voltage may be set to a voltage at which the battery module is fully discharged, or may be set depending on the actual calibration requirements. When the cell voltage of the battery module decreases to the cut-off voltage, the battery module is considered fully discharged, and the electronic control module calibrates the SOC of the battery module with an initial SOC, that is, an SOC corresponding to the voltage at which the battery module is fully discharged, thus completing the SOC calibration on the battery module, and controlling the battery module to stop discharging.

In addition, when the cell voltage of the battery module decreases to the cut-off voltage, controlling the battery module to stop discharging can implement undervoltage protection, effectively preventing the battery module from being damaged due to undervoltage and thereby improving the safety and stability of discharge calibration.

In the technical solutions of the present disclosure, the battery module interface 10, the load component 20 and the electric control component 30 are arranged. After the battery module is connected to the battery module interface 10, the electric control component 30 can perform discharge SOC calibration on the connected battery module based on the acquired cell parameter, thus achieving the SOC calibration function.

The discharge calibration apparatus for a battery module according to the present disclosure is provided with only one battery module interface 10, which is implemented in a simple connection manner and easy to operate, allowing even non-professionals to quickly use the apparatus, thus reducing the complexity and improving the applicability of the discharge calibration apparatus for a battery module. The discharge calibration apparatus for a battery module according to the present disclosure calibrates the battery module at the end of discharge of the battery module, effectively improving the accuracy of SOC calibration, prolonging the service life of the battery module after the calibration, and improving the practicality and stability of the discharge calibration apparatus for a battery module.

Referring to FIG. 1 to FIG. 3, in an embodiment, the load component 20 includes multiple electrical loads and multiple switching transistors. The multiple electrical loads are connected in parallel, the multiple switching transistors are connected in series with the multiple electrical loads in one-to-one correspondence, and controlled terminals of the multiple switching transistors are connected to the electric control component 30.

The electric control component 30 is further configured to determine a maximum output current of the battery module based on the cell parameter, and turn on a switching transistor in the load component 20 based on the maximum output current, to connect a corresponding quantity of the electrical load to the battery module.

It should be understood that the electric control component 30 may communicate with the connected battery module through the battery module interface 10 and acquire the cell parameter of the battery module, for example, a maximum charge rate or a maximum discharge rate of a cell, that is, a maximum charging current or a maximum output current of the cell. Therefore, in an embodiment, the electric control component 30 may further determine the maximum output current of the battery module based on the acquired cell parameter, and turn on a switching transistor in the load component 20 to connect a corresponding quantity of the electrical load to the battery module, so that the battery module is discharged at the maximum output current.

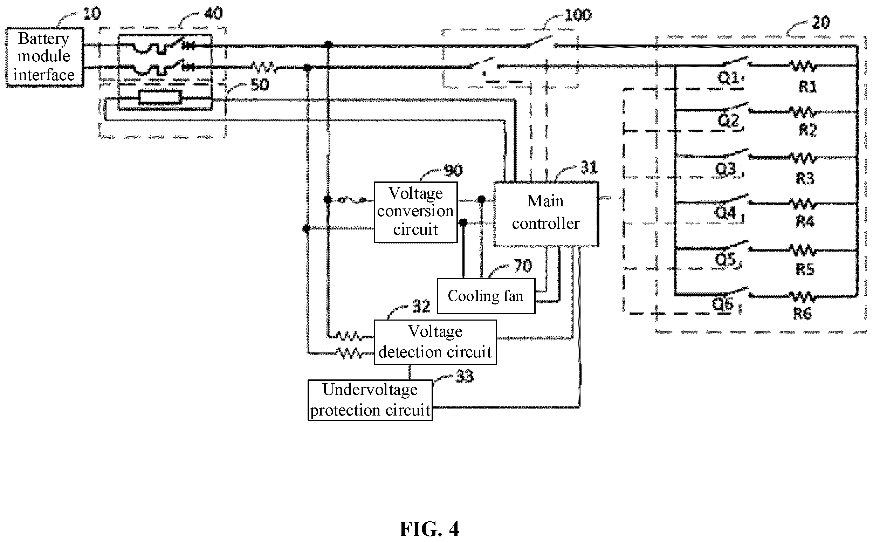

For example, reference is made to FIG. 4, which is a diagram showing a circuit structure of the load component 20. The load component 20 includes six load resistors and six switching transistors. If the output voltage of the battery module is constant, a total resistance of the load component 20 is modified, to regulate the output current of the battery module. Therefore, the electric control component 30 may control a quantity of a turned-on switching transistor to change the total resistance of the load component 20 connected to the battery module, thereby regulating the output current of the battery module.

For example, in a case that a resistance of each of the load resistors is 12Ω, an output voltage of the battery module is 24V, and the maximum output current of the battery module is 6A, the total resistance of the load component 20 is 4Ω. That is, when the electric control component 30 turns on three of the switching transistors, the output current of the battery module is the maximum output current.

In this way, the battery module is discharged at the maximum output current, accelerating the discharge speed of the battery module. In this way, the battery module can be quickly discharged to the end of discharge and the SOC calibration can be rapidly initiated, improving the calibration efficiency of the discharge calibration apparatus for a battery module.

Referring to FIG. 1 to FIG. 3, in an embodiment, the electric control component 30 is further configured to, in response to determining, based on the cell parameter, that the voltage of the battery module reaches the preset voltage threshold: control, based on the cell voltage, switching transistors in the load component 20 to sequentially disconnect the electrical loads from the battery module, to gradually reduce the output current of the battery module, and calibrate the SOC of the battery module.

During the discharge process of the battery module, the cell voltage of the battery module gradually decreases as the discharge progresses. Therefore, in an embodiment, the electric control component 30 may further determine the cell voltage of the battery module based on the cell parameter of the battery module, and turn on or off a switching transistor in the load component 20 based on the cell voltage, to gradually reduce the quantity of connected electrical loads. Thus, the output current of the battery module is gradually reduced, slowing down the decrease of the cell voltage and protecting cells.

Reference is made to FIG. 4, which is a structural diagram showing a circuit of the load component 20. The load component 20 includes six load resistors and six switching transistors. If the output voltage of the battery module is constant, a total resistance of the load component 20 is modified, to regulate the output current of the battery module. Therefore, the electric control component 30 may control a quantity of a turned-on switching transistor to change the total resistance of the load component 20 connected to the battery module, thereby regulating the output current of the battery module, achieving regulation of the output current of the battery module.

For example, in a case that five of the switching transistors are turned on, the electric control component 30 turns off any one of the five switching transistors, the total resistance of the load component 20 is increased, reducing the output current of the battery module. Therefore, the electric control component 30 may turn off multiple turned-on switching transistors one by one in the load component 20 based on the cell voltage, to gradually reduce the output current of the battery module. Thus, when the battery module is discharged to the end of discharge, the electric control component 30 can perform SOC calibration, while the output current of the battery module is gradually reduced based on the cell voltage, which can protect cells in the battery module and improve the precision of SOC calibration, thereby improving the safety and calibration precision of the discharge calibration apparatus for a battery module.

The electric control component is further configured to control, in response to determining, based on the cell parameter, that the cell voltage of the battery module is less than or equal to the cut-off voltage, the load component to stop consuming electric energy outputted by the battery module and calibrate an SOC of the battery module with an initial SOC.

Furthermore, the cut-off voltage may be set. When the cell voltage of the battery module decreases to the cut-off voltage, all switching transistors in the load component 20 are turned off, enabling the battery module to stop discharging.

The cut-off voltage may be set to a voltage at which the battery module is fully discharged, or may be set depending on the actual calibration requirements. When the cell voltage of the battery module decreases to the cut-off voltage, the battery module is considered fully discharged, and the electronic control module calibrates the SOC of the battery module with an initial SOC, that is, an SOC corresponding to the voltage at which the battery module is fully discharged, thus completing the SOC calibration on the battery module, and controlling the battery module to stop discharging. In addition, when the cell voltage of the battery module decreases to the cut-off voltage, controlling the battery module to stop discharging can implement undervoltage protection, effectively preventing the battery module from being damaged due to undervoltage and thereby improving the safety and stability of discharge calibration.

Referring to FIG. 1 to FIG. 3, in an embodiment, the electric control component 30 includes a main controller 31 and a voltage detection circuit 32.

A communication terminal of the main controller 31 is connected to the battery module interface 10, and a control terminal of the main controller 31 is connected to the load component 20. The main controller 31 is configured to, after the battery module is connected to the battery module interface 10, acquire the cell parameter of the battery module and control, based on the cell parameter, the load component 20 to consume the electric energy outputted by the battery module.

An input terminal of the voltage detection circuit 32 is connected to the battery module interface 10, and an output terminal of the voltage detection circuit 32 is connected to the main controller 31. The voltage detection circuit 32 is configured to detect, after the battery module is connected to the battery module interface 10, a battery voltage of the battery module, and output a battery voltage detection signal corresponding to the battery voltage to the main controller 31. The main controller 31 is further configured to calibrate the OCV of the connected battery module based on the battery voltage detection signal.

In the embodiment, the main controller 31 may control the discharge calibration apparatus for a battery module by using a microprocessor such as a single-chip microcomputer, FPGA, or CPLD. The voltage detection circuit 32 may adopt a voltage sensor or a voltage divider by resistors for voltage detection. The voltage detection circuit 32 may detect the battery voltage of the connected battery module, that is, a voltage across the battery module. When all the switching transistors in the load component 20 are turned off, that is, none of the electrical loads is connected to the battery module, a voltage detected by the voltage detection circuit 32 is an open-circuit voltage of the battery module. The main controller 31 may determine, based on the voltage detection signal outputted by the voltage detection circuit 32, the open-circuit voltage of the battery module, and then calibrate the OCV of the connected battery module, thereby improving the calibration precision and practicability of the discharge calibration apparatus for a battery module.

Furthermore, the main controller 31 may further estimate a current SOC of the battery module based on an OCV calibration result, and turn on a switching transistor in the load component 20 based on the estimated SOC. Thus, the output current of the battery module is regulated to an appropriate current during the battery module discharging at the maximum output current, that is, the output current is regulated in a self-adaptive manner, so that the battery module can be discharged safely and stably, improving the stability and safety of the discharge calibration apparatus for a battery module.

Referring to FIG. 1 to FIG. 3, in an embodiment, the discharge calibration apparatus for a battery module further includes a miniature circuit breaker 40 and a shunt release 50.

The miniature circuit breaker 40 is connected between the battery module interface 10 and the voltage detection circuit 32. The miniature circuit breaker 40 is configured to electrically connect, when closed, the battery module interface 10 to the voltage detection circuit 32.

The shunt release 50 is electrically connected to the main controller 31, and the shunt release 50 is interlinked with the miniature circuit breaker 40.

The main controller 31 is further configured to close the shunt release 50, in response to determining, based on the cell parameter, that the cell voltage of the battery module is less than the cut-off voltage, to trip the miniature circuit breaker 40.

**In** the embodiment, the miniature circuit breaker 40 is further arranged between the battery module interface 10 and the voltage detection circuit 32 and is configured to connect the battery module interface 10 to the voltage detection circuit 32; and disconnect the battery module interface 10 from the voltage detection circuit 32.

It should be understood that one terminal of the miniature circuit breaker 40 may be connected to the battery module interface 10, and another terminal of the miniature circuit breaker 40 may be connected to another component in the calibration apparatus required to be connected to the battery module interface 10. That is, the miniature circuit breaker 40 may be arranged between the battery module interface 10 and another component or another circuit, so that the miniature circuit breaker 40 can function as a main switch to connect the battery module to the component or the circuit, or disconnect the battery module from the component or the circuit.

**In** the embodiment, the miniature circuit breaker 40 is interlinked with the shunt release 50. The shunt release 50 is an accessory for remote control of opening. When the main controller 31 closes the shunt release 50, the shunt release 50 trips the miniature circuit breaker 40, thus disconnecting the battery module from other components or circuits. It should be understood that the battery module includes multiple cells and the main controller 31 acquires multiple cell voltages. Upon determining that a minimum cell voltage among the multiple cell voltages is less than the cut-off voltage, that is, determining that the battery module is fully discharged or the battery module is in an undervoltage state, the main controller 31 closes the shunt release 50 to trip the miniature circuit breaker 40, enabling the battery module to stop discharging, and achieving the undervoltage protection and effectively preventing the battery module from being damaged due to the undervoltage, thereby improving the safety and stability of discharge calibration.

Referring to FIG. 1 to FIG. 3, in an embodiment, the electric control component 30 further includes an undervoltage protection circuit 33.

An input terminal of the undervoltage protection circuit 33 is connected to an output terminal of the voltage detection circuit 32, and an output terminal of the undervoltage protection circuit 33 is connected to the main controller 31. The undervoltage protection circuit 33 is configured to output, upon determining undervoltage of the battery module based on the battery voltage detection signal, an undervoltage protection signal to the main controller 31, causing the main controller 31 to close the shunt release 50 to trip the miniature circuit breaker 40.

In an embodiment, the electric control component 30 is further provided with the undervoltage protection circuit 33. The undervoltage protection circuit 33 may be implemented by a comparator. A threshold voltage is applied to a first input terminal of the comparator. The threshold voltage may be set depending on actual calibration requirements. A second input terminal of the comparator is connected to the output terminal of the voltage detection circuit 32.

Thus, when the voltage detection circuit 32 detects that the battery voltage is less than the threshold voltage, the comparator outputs a high level, that is, outputs the undervoltage protection signal to the main controller 31. Thus, the main controller 31 trips, in response to the undervoltage protection signal, the micro circuit breaker 40, achieving the undervoltage protection. Alternatively, the undervoltage protection circuit 33 is integrated with a voltage detection circuit and is directly connected to the battery module interface. The undervoltage protection circuit 33 performs voltage detection and undervoltage determination.

The undervoltage protection circuit 33 determines whether the battery module is in an undervoltage state by using a hardware circuit, so that the undervoltage protection can still be achieved in event of a failure of software control, achieving dual protection. In addition, it should be understood that the battery module includes multiple cells, and the battery voltage detected by the voltage detection circuit 32 is a total voltage of the multiple cells. That is, a determination condition in which the undervoltage protection circuit 33 triggers undervoltage protection is an average cell voltage, which is different from a determination condition in which the main controller 31 triggers the undervoltage protection based on the minimum cell voltage. Therefore, the average cell voltage calculated based on the threshold voltage is slightly greater than the minimum cell voltage as the determination condition for the main controller 31, improving the stability of undervoltage protection, so that the discharge calibration apparatus for a battery module can effectively prevent the battery module from being damaged due to undervoltage, thereby improving the safety and stability of discharge calibration.

Referring to FIG. 1 to FIG. 3, in an embodiment, the discharge calibration apparatus for a battery module further includes a voltage conversion circuit 90.

An input terminal of the voltage conversion circuit 90 is connected to the battery module interface 10, and an output terminal of the voltage conversion circuit 90 is connected to the electric control component 30. The voltage conversion circuit 90 is configured to convert, after the battery module is connected to the battery module interface 10, a voltage outputted by the battery module into a power supply voltage and output the power supply voltage to the electric control component 30 for supplying the electric control component 30.

In the embodiment, the voltage conversion circuit 90 may be implemented by a DC-DC voltage conversion circuit 90. The voltage conversion circuit 90 may convert the voltage outputted by the battery module into the power supply voltage for supplying the electric control component 30. Thus, the connected battery module supplies power to the electric control component 30 without an additional power supply, accelerating the discharge speed of the battery module, thereby saving energy.

In addition, the voltage conversion circuit 90 may further supply power to other functional components or functional circuits in the discharge calibration apparatus for a battery module. Thus, a power utilization rate of the battery module is improved, achieving energy conservation and environmental protection.

Referring to FIG. 1 to FIG. 3, in an embodiment, the discharge calibration apparatus for a battery module further includes a cooling fan 70 and a temperature detection module.

A controlled terminal of the cooling fan 70 is connected to the electric control component 30.

The temperature detection module is connected to the electric control component 30. The temperature detection module is configured to detect a temperature of the load component 20 and a temperature of an air outlet of the cooling fan 70 and output temperature detection signals corresponding to the temperatures. The electric control component 30 controls operation of the cooling fan based on the temperature detection signal; and/or the electric control component 30 turns on a corresponding switching transistor in the load component 20 based on the temperature detection signal, to regulate the output current of the battery module.

In an embodiment, the temperature detection module includes a first temperature sensor 60 and a second temperature sensor 80.

The first temperature sensor 60 is connected to the electric control component 30. The first temperature sensor 60 is configured to detect the temperature of the load component 20 and output a first temperature detection signal corresponding to the temperature. The electric control component 30 controls, based on the first temperature detection signal, the cooling fan 70 to operate to cool the load component 20.

The second temperature sensor 80 is arranged at the air outlet of the cooling fan 70. The second temperature sensor 80 is configured to detect the temperature of the air outlet of the cooling fan 70 and output a second temperature detection signal corresponding to the temperature. The electric control component 30 turns on a corresponding switching transistor in the load component 20 based on the first temperature detection signal and the second temperature detection signal, to regulate the output current of the battery module.

It should be understood that the discharge calibration apparatus for a battery module is provided with the load component 20 for consuming the electric energy outputted by the battery module, and the load component 20 includes multiple electrical loads. Thus, the load component 20 generates a large amount of heat when discharging the battery module. In an embodiment, the discharge calibration apparatus for a battery module is further provided with the first temperature sensor 60 and the cooling fan 70. The first temperature sensor 60 is configured to detect the temperature of the load component 20. Upon determining, based on the first temperature detection signal, that the temperature of the load component 20 is higher than a preset temperature threshold, the electric control component 30 controls the cooling fan 70 to cool the load component 20.

Furthermore, the discharge calibration apparatus for a battery module is further provided with multiple temperature sensors for multiple-point control on components in the discharge calibration apparatus, in order to cool the components in the discharge calibration apparatus in a timely manner, preventing the discharge calibration apparatus for a battery module and the battery module from being damaged due to overheating and thereby improving the safety of the discharge calibration apparatus for a battery module.

The second temperature sensor 80 is further arranged at the air outlet of the cooling fan 70 to detect the temperature of the air outlet of the cooling fan 70. The electric control component 30 may further regulate, based on the temperature detected by the first temperature sensor 60 and the temperature detected by the second temperature sensor 80, the output current of the battery module, to regulate the temperature inside the discharge calibration apparatus for a battery module, thereby protecting users from being burned by a high temperature at the air outlet.

Furthermore, the discharge calibration apparatus for a battery module is further provided with multiple temperature sensors for multiple-point control on components in the discharge calibration apparatus, in order to cool the components in the discharge calibration apparatus in a timely manner, and facilitate regulation of the output current of the battery module. Thus, the temperature inside the apparatus is maintained within a safe temperature range, preventing the discharge calibration apparatus for a battery module and the battery module from being damaged due to overheating, and protecting users from being burned by the high temperature at the air outlet, thereby improving the safety of the discharge calibration apparatus for a battery module.

Referring to FIG. 1 to FIG. 3, in an embodiment, the discharge calibration apparatus for a battery module further includes a main switching circuit 100.

The main switching circuit 100 is arranged between the load component 20 and the battery module interface 10. A controlled terminal of the main switching circuit 100 is connected to the electric control component 30. The main switching circuit 100 is configured to electrically connect, when closed, the load component 20 to the battery module interface 10.

In an embodiment, the main switching circuit 100 is further arranged between the load component 20 and the battery module interface 10. The main switching circuit 100 may be implemented by a switching device, such as a circuit breaker or a relay, to connect the load component 20 to the battery module interface 10, or disconnect the load component 20 from the battery module interface 10. In such case, the electric control component 30 fails to control the load component 20 in event of a failure of the load component 20, the electric control component 30 may control the main switch circuit 100 to disconnect the load component 20 electrically from the battery module interface 10, so that the battery module stops discharging, preventing the battery module and the load component 20 from being damaged, improving the safety of the discharge calibration apparatus for a battery module.

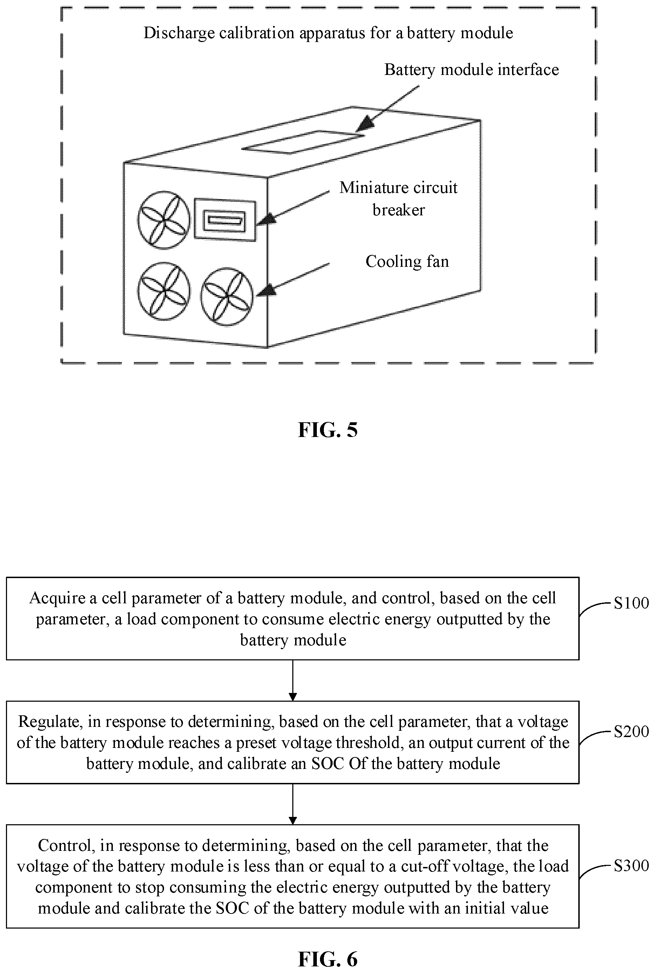

Based on the discharge calibration apparatus for a battery module described above, a discharge calibration method for a battery module is further provided according to the present disclosure. Referring to FIG. 6, in an embodiment, the discharge calibration method includes the following steps S100 to S300.

In step S100, a cell parameter of the battery module is acquired, and the load component 20 is controlled, based on the cell parameter, to consume electric energy outputted by the battery module.

In step S200, in response to determining, based on the cell parameter, that the voltage of the battery module reaches the preset voltage threshold, an output current of the battery module is regulated based on the cell parameter and the SOC of the battery module is calibrated.

In step S300, in response to determining, based on the cell parameter, that the voltage of the battery module is less than or equal to a cut-off voltage, the load component 20 is controlled to stop consuming the electric energy outputted by the battery module and the SOC of the battery module is calibrated with an initial SOC.

In the embodiment, after the battery module is connected to the battery module interface 10, the electric control component 30 establishes a communication connection with the BMU in the battery module, and acquires the cell parameter of the battery module, such as an SOC, a cell voltage, a cell discharge rate or the like, from the BMU. The electric control component 30 may turn on a switching transistor in the load component 20 based on the acquired cell parameter to electrically connect the electrical loads to the battery module, enabling the battery module to discharge.

The preset voltage threshold of the battery module is a voltage corresponding to the SOC at the end of discharge of the battery module, that is, a voltage corresponding to an SOC of 10% or below to which the battery module is discharged. Upon determining, based on the cell parameter, that the battery module reaches the preset voltage threshold, the electric control component 30 may further turn on or off the switching transistors in the load component 20 to change the quantity of electrical loads connected to the battery module. In this way, the output current of the battery module is regulated, that is, the discharge speed of the battery module is changed, and the SOC of the battery module is calibrated during regulating the output current of the battery module. In an embodiment, the electric control component 30 may turn on or off the switching transistors in the load component 20 to gradually reduce the quantity of connected electrical loads, so that the output current of the battery module is gradually reduced and thereby slowing down the decrease of the cell voltage, and improving the precision of SOC calibration while protecting cells in the battery module. A frequency at which the electric control component 30 regulates the output current may be set depending on a calibration frequency. For example, the output current is reduced once every time the SOC is calibrated until the calibration is completed.

Furthermore, the frequency at which the electric control component 30 regulates the output current and the calibration frequency may further be set depending on the cell voltage of the battery module. For example, every time the cell voltage of the battery module decreases by a preset value, the SOC is calibrated once and the output current is reduced once until the calibration is completed.

When the cell voltage of the battery module decreases to the cut-off voltage, all switching transistors in the load component 20 are turned off, enabling the battery module to stop discharging. The cut-off voltage may be set to a voltage at which the battery module is fully discharged, or may be set depending on actual calibration requirements. When the cell voltage of the battery module decreases to the cut-off voltage, the battery module is considered fully discharged, and the electronic control module calibrates the SOC of the battery module with an initial SOC, that is, an SOC corresponding to the voltage at which the battery module is fully discharged, thus completing the SOC calibration on the battery module, and controlling the load component 20 to stop consuming the electric energy outputted by the battery module.

In the technical solutions of the present disclosure, the connected battery module is discharged by the load component 20, the electric energy outputted by the battery module can reaches the end of discharge, and at the end of discharge, the output current of the battery module is regulated based on the acquired cell parameter and the SOC of the connected battery module is calibrated, achieving the SOC calibration function. According to the present disclosure, the output current of the battery module is regulated based on the cell parameter during the SOC calibration, improving the precision of SOC calibration while protecting cells in the battery module, effectively improving accuracy of the SOC calibration and prolonging the service life of the calibrated battery module.

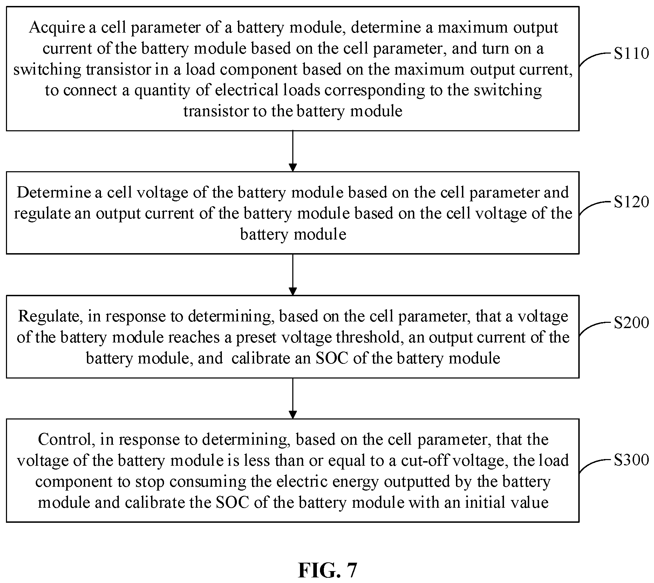

Referring to FIG. 7, in an embodiment, the process of acquiring the cell parameter of the battery module and controlling, based on the cell parameter, the load component 20 to consume the electric energy outputted by the battery module includes the following steps S110, S120, S200 and S300.

In step S110, the cell parameter of the battery module is acquired, a maximum output current of the battery module is determined based on the cell parameter, and a switching transistor in the load component 20 is turned on based on the maximum output current, to connect a corresponding quantity of the electrical load to the battery module.

It should be understood that the electric control component 30 may communicate with the connected battery module through the battery module interface 10 and acquire the cell parameter of the battery module, for example, a maximum charge rate or a maximum discharge rate of a cell, that is, a maximum charging current or a maximum output current of the cell. Therefore, in an embodiment, the electric control component 30 may further determine the maximum output current of the battery module based on the acquired cell parameter, and turn on a switching transistor in the load component 20 to connect a corresponding quantity of the electrical load to the battery module, so that the battery module is discharged at the maximum output current.

For example, reference is made to FIG. 4, which is a structural diagram showing a circuit of the load component 20 according to an embodiment. The load component 20 includes six load resistors and six switching transistors. If an output voltage of the battery module is constant, a total resistance of the load component 20 is modified, to regulate the output current of the battery module. Therefore, the electric control component 30 may control a quantity of a turned-on switching transistor to change the total resistance of the load component 20 connected to the battery module, thereby regulating the output current of the battery module. For example, in a case that a resistance of each of the load resistors is 12Ω, an output voltage of the battery module is 24V, and the maximum output current of the battery module is 6A, the total resistance of the load component 20 is 4Ω. That is, when the electric control component 30 turns on three of the switching transistors, the output current of the battery module is the maximum output current. In this way, the battery module is discharged at the maximum output current, accelerating the discharge speed of the battery module. In this way, the battery module can be quickly discharged to the end of discharge and the SOC calibration can be rapidly initiated, improving the calibration efficiency of the discharge calibration apparatus for a battery module.

In step S120, the cell voltage of the battery module is determined based on the cell parameter and the output current of the battery module is regulated based on the cell voltage of the battery module.

The electric control component 30 may further determine the cell voltage of the battery module based on the cell parameter, and turn on a switching transistor in the load component 20 based on the cell voltage of the battery module. Thus, the output current of the battery module is regulated to an appropriate current during the battery module discharging at the maximum output current, that is, the output current is regulated in a self-adaptive manner, so that the battery module can be discharged safely and stably, improving the stability and safety of the discharge calibration apparatus for a battery module.

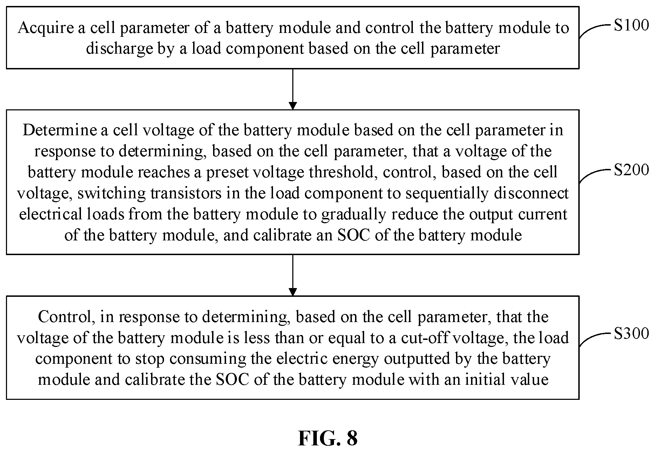

Referring to FIG. 8, in an embodiment, the process of regulating, in response to determining, based on the cell parameter, that the voltage of the battery module reaches the preset voltage threshold, the output current of the battery module based on the cell parameter and calibrating the SOC of the battery module includes: in response to determining, based on the cell parameter, that the voltage of the battery module reaches the preset voltage threshold, determining the cell voltage of the battery module based on the cell parameter; controlling, based on the cell voltage, switching transistors in the load component 20 to sequentially disconnect electrical loads from the battery module to gradually reduce the output current of the battery module; and calibrating the SOC of the battery module.

It should be understood that, during a discharge process of the battery module, the cell voltage in the battery module gradually decreases as the discharge progresses. Therefore, the cell voltage of the battery module may be further determined based on the cell parameter of the battery module, and the switching transistors in the load component 20 are turned on or off based on the cell voltage, to gradually reduce the quantity of connected electrical loads. Thus, the output current of the battery module is gradually reduced, slowing down the decrease of the cell voltage, thereby improving the precision of SOC calibration while protecting the cells.

Reference is made to FIG. 4, which is a structural diagram showing a circuit of the load component 20. The load component 20 includes six load resistors and six switching transistors. If the output voltage of the battery module is constant, a total resistance of the load component 20 is modified, to regulate the output current of the battery module. Therefore, the electric control component 30 may control a quantity of a turned-on switching transistor to change the total resistance in the load component 20 connected to the battery module, thereby regulating the output current of the battery module, achieving regulation of the output current of the battery module.

For example, assume that five of the switching transistors are turned on. If the electric control component 30 turns off any one of the five switching transistors, the total resistance of the load component 20 is increased, thus reducing the output current of the battery module. Therefore, the electric control component 30 may turn off multiple turned-on switching transistors one by one in the load component 20 based on the cell voltage, to gradually reduce the output current of the battery module. A frequency at which the electric control component 30 regulates the output current may be set depending on a calibration frequency. For example, the output current is reduced once every time the SOC is calibrated until the calibration is completed. Further, the frequency at which the electric control component 30 regulates the output current and the calibration frequency may further be set depending on the cell voltage of the battery module. For example, every time the cell voltage of the battery module decreases by a preset value, the SOC is calibrated once and the output current is reduced once until the calibration is completed.

The above descriptions are merely the embodiments of the present disclosure and are not intended to limit the protection scope of the present disclosure. With the inventive concept of the present disclosure, any equivalent structural transformation made by using the content of descriptions and drawings of the present disclosure, or direct/indirect implementations in other related technical fields, are included in the protection scope of the present disclosure.

## Claims

1. A discharge calibration apparatus for a battery module, comprising:
a battery module interface, configured to connect the battery module;
a load component, electrically connected to the battery module interface, and configured to consume electric energy outputted by the battery module after the battery module is connected to the battery module interface; and
an electric control component, wherein
a communication terminal of the electric control component is connected to the battery module interface, and a control terminal of the electric control component is connected to the load component;
the electric control component is configured to, after the battery module is connected to the battery module interface:
acquire a cell parameter of the battery module; and
control, based on the cell parameter, the load component to consume the electric energy outputted by the battery module; and
the electric control component is further configured to, in response to determining, based on the cell parameter, that a voltage of the battery module reaches a preset voltage threshold:
regulate an output current of the battery module based on the cell parameter; and
calibrate an SOC of the battery module.

2. The discharge calibration apparatus for a battery module according to claim 1, wherein the load component comprises a plurality of electrical loads and a plurality of switching transistors, wherein
the plurality of electrical loads are connected in parallel, and the plurality of switching transistors are connected in series with the plurality of electrical loads in one-to-one correspondence; and
controlled terminals of the plurality of switching transistors are connected to the electric control component, wherein
the electric control component is further configured to:
determine a maximum output current of the battery module based on the cell parameter; and
turn on a switching transistor of the plurality of switching transistors in the load component based on the maximum output current to connect a quantity of electrical loads corresponding to the switching transistor among the plurality of electrical loads to the battery module.

3. The discharge calibration apparatus for a battery module according to claim 2, wherein the electric control component is further configured to, in response to determining, based on the cell parameter, that the cell voltage of the battery module reaches the preset voltage threshold:
control, based on the cell voltage, the plurality of switching transistors in the load component to sequentially disconnect the plurality of electrical loads from the battery module, to gradually reduce the output current of the battery module, and
calibrate the SOC of the battery module.

4. The discharge calibration apparatus for a battery module according to claim 3, wherein the electric control component is further configured to, in response to determining, based on the cell parameter, that the voltage of the battery module is less than or equal to a cut-off voltage:
control the load component to stop consuming the electric energy outputted by the battery module; and
calibrate the SOC of the battery module with an initial SOC.

5. The discharge calibration apparatus for a battery module according to claim 1, wherein the electric control component comprises:
a main controller, wherein,
a communication terminal of the main controller is connected to the battery module interface, and a control terminal of the main controller is connected to the load component; and
the main controller is configured to, after the battery module is connected to the battery module interface: acquire the cell parameter of the battery module and control, based on the cell parameter, the load component to consume the electric energy outputted by the battery module; and
a voltage detection circuit, wherein
an input terminal of the voltage detection circuit is connected to the battery module interface, and an output terminal of the voltage detection circuit is connected to the main controller;
the voltage detection circuit is configured to, after the battery module is connected to the battery module interface: detect a battery voltage of the battery module and output a battery voltage detection signal corresponding to the battery voltage to the main controller;
wherein the main controller is further configured to calibrate the OCV of the connected battery module based on the battery voltage detection signal.

6. The discharge calibration apparatus for a battery module according to claim 1, further comprising:
a miniature circuit breaker, connected between the battery module interface and the load component, wherein the miniature circuit breaker is configured to electrically connect, when closed, the battery module interface and the load component; and
a shunt release, electrically connected to the electric control component, and interlinked with the miniature circuit breaker;
wherein the electric control component is further configured to, in response to determining, based on the cell parameter, that the cell voltage of the battery module is less than a cut-off voltage:
close the shunt release to trip the miniature circuit breaker.

7. The discharge calibration apparatus for a battery module according to claim 6, further comprising an undervoltage protection circuit, wherein
an input terminal of the undervoltage protection circuit is connected to the battery module interface, and an output terminal of the undervoltage protection circuit is connected to a main controller; and
the undervoltage protection circuit is configured to:
detect a battery voltage of the battery module after the battery module is connected to the battery module interface; and
output, upon determining undervoltage of the battery module, an undervoltage protection signal to the main controller, wherein the main controller closes, in response to the undervoltage protection signal, the shunt release to trip the miniature circuit breaker.

8. The discharge calibration apparatus for a battery module according to claim 1, further comprising a voltage conversion circuit, wherein
an input terminal of the voltage conversion circuit is connected to the battery module interface, and an output terminal of the voltage conversion circuit is connected to the electric control component; and
the voltage conversion circuit is configured to convert, after the battery module is connected to the battery module interface, a voltage outputted by the battery module into a power supply voltage and output the power supply voltage to the electric control component for supplying the electric control component.

9. The discharge calibration apparatus for a battery module according to claim 1, further comprising:
a cooling fan, wherein a controlled terminal of the cooling fan is connected to the electric control component; and
a temperature detection module, connected to the electric control component, wherein the temperature detection module is configured to:
detect a temperature of the load component and a temperature of an air outlet of the cooling fan; and
output temperature detection signals corresponding to the temperatures, wherein
the electric control component controls operation of the cooling fan based on the temperature detection signal; and/or
the electric control component turns on a switching transistor in the load component based on the temperature detection signal, to regulate an output current of the battery module.

10. The discharge calibration apparatus for a battery module according to claim 9, wherein the temperature detection module comprises:
a first temperature sensor, connected to the electric control component, wherein the first temperature sensor is configured to:
detect the temperature of the load component; and
output a first temperature detection signal corresponding to the temperature of the load component, wherein the electric control component controls operation of the cooling fan based on the first temperature detection signal, to cool the load component; and
a second temperature sensor, arranged at the air outlet of the cooling fan, wherein the second temperature sensor is configured to:
detect the temperature of the air outlet of the cooling fan; and
output a second temperature detection signal corresponding to the temperature of the air outlet, wherein the electric control component turns on the corresponding switching transistor in the load component based on the first temperature detection signal and the second temperature detection signal, to regulate the output current of the battery module.

11. The discharge calibration apparatus for a battery module according to claim 1, further comprising a main switching circuit, wherein
the main switching circuit is arranged between the load component and the battery module interface;
a controlled terminal of the main switching circuit is connected to the electric control component; and
the main switching circuit is configured to electrically connect, when connected, the load component to the battery module interface.

12. A discharge calibration method for a battery module, applied to the discharge calibration apparatus for a battery module according to any one of claims 1 to 11, comprising:
acquiring the cell parameter of the battery module, and controlling, based on the cell parameter, the load component to consume the electric energy outputted by the battery module;
regulating, in response to determining, based on the cell parameter, that the voltage of the battery module reaches the preset voltage threshold, the output current of the battery module based on the cell parameter and calibrating the SOC of the battery module; and
controlling, in response to determining, based on the cell parameter, that the voltage of the battery module is less than or equal to a cut-off voltage, the load component to stop consuming the electric energy outputted by the battery module and calibrating the SOC of the battery module with an initial SOC.

13. The discharge calibration method for a battery module according to claim 12, wherein the acquiring the cell parameter of the battery module, and controlling, based on the cell parameter, the load component to consume the electric energy outputted by the battery module comprises:
acquiring the cell parameter of the battery module, determining a maximum output current of the battery module based on the cell parameter, and turning on a switching transistor in the load component based on the maximum output current, to connect a quantity of an electrical load corresponding to the switching transistor to the battery module; and
determining the cell voltage of the battery module based on the cell parameter and regulating the output current of the battery module based on the cell voltage of the battery module.

14. The discharge calibration method for a battery module according to claim 12, wherein the regulating, in response to determining, based on the cell parameter, that the voltage of the battery module reaches the preset voltage threshold, the output current of the battery module based on the cell parameter and calibrating the SOC of the battery module comprises:
in response to determining, based on the cell parameter, that the voltage of the battery module reaches the preset voltage threshold,
controlling, based on the cell voltage, a plurality of switching transistors in the load component to sequentially disconnect a plurality of electrical loads from the battery module based on the cell voltage to gradually reduce the output current of the battery module; and
calibrating the SOC of the battery module.
